# EUROPEAN PATENT APPLICATION

(11) **EP 2 246 905 A2**
(43) Date of publication of application: **03.11.2010**
(21) Application number: 10161069.9
(22) Date of filing: 26.04.2010
(51) Int. Cl.: H01L 31/068, H01L 31/0352

(54) **Multijunction photovoltaic structure with three-dimensional subcell and method thereof**

(30) Priority: 27.04.2009 US 430308
(71) Applicant: Sharp Kabushiki Kaisha, Osaka 545 (JP)
(72) Inventor: Smith, Katherine Louise, Oxford, Oxfordshire OX4 4GB (GB); Altebaeumer, Thomas Heinz-Helmut, Oxford, Oxfordshire OX4 4GB (GB); Huang, James Ying Jun, Oxford, Oxfordshire OX4 4GB (GB); Dimmock, James Andrew Robert, Oxford, Oxfordshire OX4 4GB (GB)
(74) Representative: Suckling, Andrew Michael

(57) **Abstract**

A multijunction photovoltaic structure includes a first subcell including a p-n or p-i-n junction with elongated structures; and a second subcell, arranged in tandem with the first subcell, and including a planar p-n or p-i-n junction. The elongated structure is a structure that has a height being larger than at least one of its other two dimensions. This ensures a thicker first subcell, which improves the uniformity of the structure and provides a structure that is quicker and easier to fabricate.

## Description

### FIELD OF THE INVENTION

This invention relates to multijunction photovoltaic devices and a method for forming a multijunction photovoltaic structure.

### BACKGROUND OF THE INVENTION

At present commercial solar cells are either based on silicon or III-V compound semiconductor materials. Solar cells are classified as either single junction or multijunction solar cells according to their structure. A single junction solar cell only absorbs light from the region of the spectrum with photon energy greater than its single band gap. The efficiency is limited by transmission and thermalisation losses in the solar cell. If an incident photon has less energy than the band gap of the semiconductor material, the photon cannot be absorbed since there is not enough energy to excite an electron from the conduction band to the valence band. If an incident photon has more energy than the band gap the excess energy will be converted into heat.

Multijunction solar cells (also known as tandem solar cells) use a combination of semiconductor materials stacked in a series of subcells to more efficiently capture and convert a larger range of photon energies such as ultraviolet, visible and infra-red light. Two technological approaches have been investigated over the years. Firstly a mechanically stacked approach where solar cells with different band gap energies are fabricated on their individual substrates and then brought together such that the solar cell consists of a stack of subcells. This allows subcell materials to have different lattice constants. However, separate substrates are required for each subcell and complicated processing is required for the mechanical stacking procedure. Secondly, the monolithic approach where different materials are all grown on a single substrate and connected in series by interband tunnel diodes. In this approach the various materials need to be lattice matched to the substrate. Only one substrate is needed which is a cost advantage compared with the mechanically stacked approach and while the growth of the monolithic solar cell structure may be more complicated for III-V materials, the processing is simpler and cheaper than the mechanically stacked approach. Due to the fact that the subcells are connected in series the output current of the monolithic multijunction solar cell is limited to the smallest of the currents produced by any of the individual subcells. Ideally the same current is generated in each of the subcells i.e. the subcells are 'current matched.' This will result in a higher efficiency from the whole photovoltaic device.

Microcrystalline silicon (hereafter referred to as µc-Si) has a band gap of 1.1eV, compared with the 1.7eV band gap of amorphous silicon (hereafter referred to as a-Si). Therefore µc-Si is suitable for use as the bottom subcell of a multijunction solar cell with a-Si as the top subcell. In fact the 1.7eV/1.1eV combination provides a nearly ideal band gap pair for tandem cells. The advantages of using µc-Si as the narrow band gap cell instead of the alternative of amorphous SiGe (a-SiGe) are (1) the higher quantum efficiency in the long-wavelength region, (2) negligible light induced degradation, (3) reduced materials cost, since µc-Si can be made using SiH4, which is a relatively low cost gas compared to GeH4, and (4) µc-Si cells can be made with a high fill factor. On the other hand, concern associated with using µc-Si compared to an a-SiGe bottom cell is µc-Si cells require much thicker i-layers (several µm thick) to absorb the sunlight; this is an effect of the lower interband absorption coefficients in indirect band gap crystals compared to amorphous semiconductors. *[*Handbook of Photovoltaic Science and Engineering by Antonio Luque and Ateven Hegedus, published by Wiley 2003*]*. An example of a tandem silicon solar cell is given in US4272641, issued June 9, 1981.

At present, the most efficient commercial multijunction solar cell is a monolithic triple junction device with subcells consisting of Ga_{0.5}In_{0.5}P, Ga_{0.99}In_{0.01}As and Ge. However, the Ge subcell in this device usually absorbs about the same number of photons as the GaInP and GaInAs layers combined. A higher efficiency would be achieved if a 1eV material were added between the GaInAs and Ge subcells as this would result in closer current matching for all of the subcells and a higher overall cell efficiency. In order to be incorporated into a monolithic device this 1eV material also needs to be lattice matched to germanium.

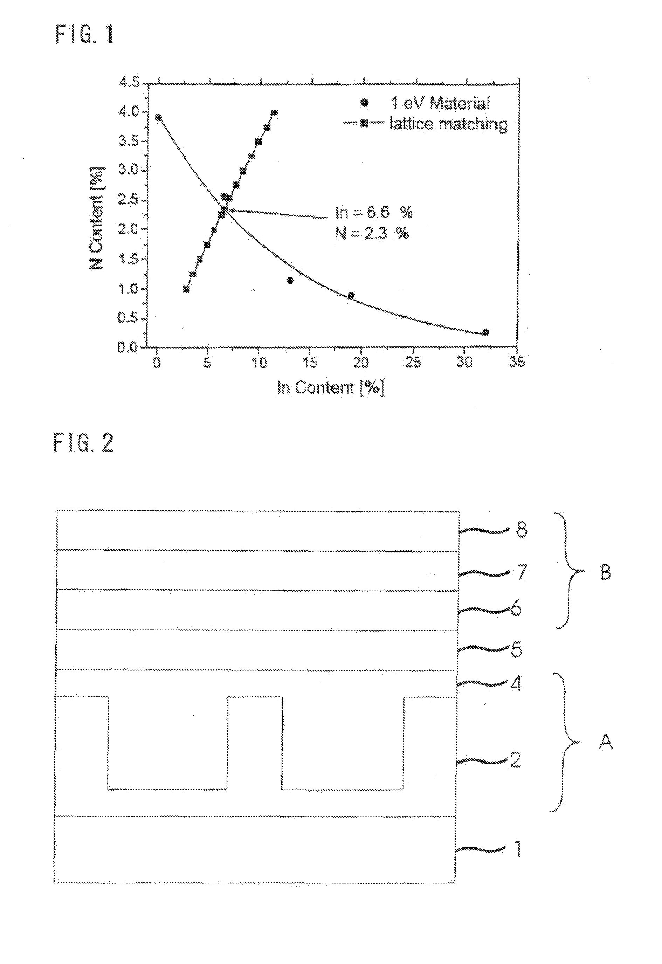

GaInNAs is one example of a material which can fulfil these requirements. There is a significant bowing of the GaInAs band gap when introducing small amounts of nitrogen. Figure 1 represents a range of In and N compositions, for which lattice matching (squares) occurs and for which the samples have a fundamental band gap of 1eV (circles). The desired 1eV band gap can be achieved by using several different compositions, which are plotted as circles in Figure 1. Additionally, lattice matching conditions to GaAs (which is very close to that of germanium, and is a possible alternative substrate) are shown as squares in Figure 1. At the composition where both curves intersect, the lattice matching condition as well as the 1eV band gap requirement is fulfilled. This material has a composition of 8% indium and 2.8% nitrogen *[*K Volz et al, J. Cryst. Growth 248, 451 (2003*)]*.

The concept of using GaInNAs as a 1eV material lattice matched to GaAs or Ge in a solar cell has been widely discussed in the literature *[*D. J. Friedman et al. J. Cryst. Growth 195, 409 (1998*)]*. However, problems with the material quality result in disadvantages such as shorter carrier diffusion length (due to low mobility and short carrier lifetime), and high impurity concentration (US2007/0151595A1, published July 5, 2007) resulting in a high background doping concentration. As a result the power conversion efficiency and photocurrent achievable is not sufficient for implementation in a four-junction photovoltaic device. Some suggestions have previously been presented to use a GaInNAs subcell despite these limitations. For example, US2007/0151595A1 discusses the use of a superlattice structure, and M. Meusel et al. ["European roadmap for the development of III-V multi-junction space solar cells", 19th European Photovoltaic Solar Energy Conference, 2004*]* discusses incorporating a GaInNAs p-n junction as the fifth subcell in a six-junction solar cell (0.7eV/1.1eV/1.4eV/1.6eV/1.9eV/2.2eV). This structure generates only half the current density of a 1.9eV/1.4eV/0.7eV solar cell and the requirement on the GaInNAs photocurrent is therefore reduced.

### SUMMARY OF THE INVENTION

According to one aspect of the invention, a multijunction photovoltaic structure is provided. The structure includes a first subcell including a p-n or p-i-n junction with elongated structures, wherein the elongated structure is a structure that has a height larger than at least one of a length and a width, and a second subcell, arranged in tandem with the first subcell, and including a planar p-n or p-i-n junction.

The elongated structure is a structure that has a height (Y) being larger than at least one of its other two dimensions (i.e., width) (X2), and its height (Y), width (X2), and a pitch (X1) follow the following relationship: Y>X2 and X1>X2.

In another aspect, a pitch (X1) of the elongated structures of the first subcell is between 10nm and 10µ m.

With regard to another aspect, a width (X2) of the elongated structures of the first subcell is between 10nm and 10 µ m.

In yet another aspect, a height (Y) of the elongated structures of the first subcell is between 10nm and 10 µ m.

According to another aspect, the p-n junction with elongated structures of the first subcell comprise a p-type or n-type layer with three-dimensional structures formed therein, and the other of the p-type or n-type layer deposited on top thereof.

According to still another aspect, the other of the p-type or n-type layer is planarized.

According to another aspect, the p-i-n junction with elongated structures of the first subcell include a p-type or n-type layer with three-dimensional structures formed therein, an intrinsic layer deposited on top thereof, and the other of the p-type or n-type layer formed on top of the intrinsic layer.

In accordance with another aspect, the intrinsic layer is planarized.

According to still another aspect, the elongated structures of the first subcell include respective layers of the p-n or p-i-n junction deposited conformally on top of a substrate or underlying layer having three-dimensional structures corresponding to the elongated structures.

In accordance with yet another aspect, the first subcell and the second subcell have different band gap energies and the elongated structures improve current matching between the first subcell and the second subcell.

According to another aspect, the first subcell is one of a µ c-Si subcell and an a-Si subcell, and the second subcell is the other of a µ c-Si subcell and an a-Si subcell.

In still another aspect, the first subcell is an GaInNAs subcell.

In yet another aspect, the multijunction photovoltaic structure further includes a tunnel junction separating the first subcell and the second subcell.

According to another aspect, the multijunction photovoltaic structure further includes at least one additional subcell in tandem with the first subcell, said additional subcell having either a p-n or p-i-n junction with elongated structures, or a planar p-n or p-i-n junction.

According to still another aspect, the at least one additional subcell comprises a p-n or p-i-n junction with elongated structures.

According to yet another aspect, the at least one additional subcell comprises a planar p-n or p-i-n junction.

According to still another aspect, the elongated structures comprise at least one of ribs or pillars.

With regard to another aspect, a method for forming a multijunction photovoltaic structure is provided. The method includes forming a first subcell including a p-n or p-i-n junction with elongated structures, wherein the elongated structure is a structure that has a height larger than at least one of a length and a width, and forming a second subcell, arranged in tandem with the first subcell, and including a planar p-n or p-i-n junction.

According to still another aspect, the method includes forming a p-type or n-type layer of the first subcell including the p-n junction with three-dimensional structures therein, depositing the other of the p-type or n-type layer thereon.

In accordance with yet another aspect, the method includes forming a p-type or n-type layer of the first subcell including the p-i-n junction with three-dimensional structures therein, depositing an intrinsic layer thereon, and forming the other of the p-type or n-type layer on top of the intrinsic layer.

According to another aspect, the method includes forming the elongated structures of the first subcell by depositing the respective layers of the p-n or p-i-n junction conformally on top of a substrate or underlying layer having three-dimensional structures corresponding to the elongated structures.

According to still another aspect, the method includes forming at least one additional subcell in tandem having either a p-n or p-i-n junction with elongated structures, or a planar p-n or p-i-n junction.

In yet another aspect, the first subcell is one of a µ c-Si subcell and an a-Si subcell, and the second subcell is the other of a µ c-Si subcell and an a-Si subcell.

According to another aspect, the first subcell is GaInNAs subcell.

According to still another aspect, the elongated structures include at least one of ribs or pillars.

For the purposes of this invention a planar layer or surface is defined such that any feature in a layer or surface has an aspect ratio lower than one, i.e. the dimensions of a feature in the plane of the substrate are larger than the dimension of the feature perpendicular to the substrate. The layer or surface is considered to contain elongated structures (i.e. is 3D structured) if at least one dimension of a feature in the plane of the substrate (i.e., a length or width) is less than the dimension of the feature perpendicular to the plane of the substrate (i.e., height). By way of example only, an elongated structure may take the form of pillars (in which both dimensions in the plane of the substrate are less than the dimension of the feature perpendicular to the substrate) or fins (in which only one dimension in the plane of the substrate is less than the dimension of the feature perpendicular to the substrate). Various other forms of elongate structures also are possible, and are well within the scope of the invention.

The present invention discloses the use of a p-n or p-i-n junction with elongated structures in a subcell of a multijunction photovoltaic structure with at least one other planar subcell deposited on top of the 3D structured subcell. Advantageously, such a construction is particularly suited for fabrication using the processing techniques described in commonly assigned, co-pending UK patent application 0813568.3, which describes methods of growing solar cell films conformally on a nanostructured surface of a substrate.

It is to be understood that the figures provided show a simplified, schematic version of solar cells to illustrate the key features of the present invention. Other layers that are typically used in photovoltaic devices, which are omitted here for clarity, may also be included in the structures provided to enable the optimum use of the present invention. These layers may include but are not limited to: further subcells, nucleation layers, buffer layers, back surface field layers, tunnel junctions, window layers and contact layers. The present invention is described with the formation of the solar cell layers on an n-doped substrate. It would be equally possible to apply the present invention to a device formed on a p-doped substrate, by reversing the order of the p-doped and n-doped layers in each subcell.

An object of the present invention is to enable a gain in the efficiency of multijunction photovoltaic devices by decoupling the requirements based on the necessary absorption depth and the possible minority carrier diffusion length in the material of a subcell; and/or to provide a structure that is quicker and easier to fabricate compared with present technology. The present invention enables a photovoltaic device fabricated in any suitable material system with the presence of a p-n junction or p-i-n junction forming elongated structures in at least one subcell, with at least one planar subcell in tandem with the subcell containing elongated structures. The photovoltaic device may be fabricated by any suitable method; this includes but is not limited to molecular beam epitaxy, chemical beam epitaxy, vapour phase epitaxy, chemical vapour deposition, spin coating, ink-jet printing, stamp-based transfers, device bonding and transfer of the desired structures out of solution.

To the accomplishment of the foregoing and related ends, the invention, then, comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

Figure 1 represents a range of In and N compositions, for which lattice matching occurs and for which samples have a fundamental band gap of 1eV;
Figures 2 thru 8 illustrate in cross-section basic structures of a multijunction solar cell in accordance with respective embodiments of the present invention;
Figure 9 illustrates an exemplary configuration of elongated structures in accordance with an embodiment of the present invention;
Figures 10 and 11 illustrate exemplary respective elongated structures in accordance with the present invention;
Figure 12 illustrates in detailed cross-section a first configuration of a multifunction solar cell in accordance with an exemplary embodiment of the present invention;
Figure 13 illustrates in detailed cross-section a second configuration of a multifunction solar cell in accordance with an exemplary embodiment of the present invention;
Figure 14 illustrates in detailed cross-section a third configuration of a multifunction solar cell in accordance with an exemplary embodiment of the present invention;
Figure 15 illustrates in detailed cross-section a fourth configuration of a multifunction solar cell in accordance with an exemplary embodiment of the present invention;
Figures 16 and 17 represent exemplary planar and elongate unit subcell structures, respectively, for purposes of computer modelling.

### DESCRIPTION OF THE EMBODIMENTS

### [First Embodiment]

The present invention will now be described in detail with reference to the drawings.

Figures 2 thru 8 illustrate exemplary structures of subcells in a multijunction solar cell according to the present invention. As described herein, the subcells include one or more three-dimensional (3D) subcells in stacked arrangement.

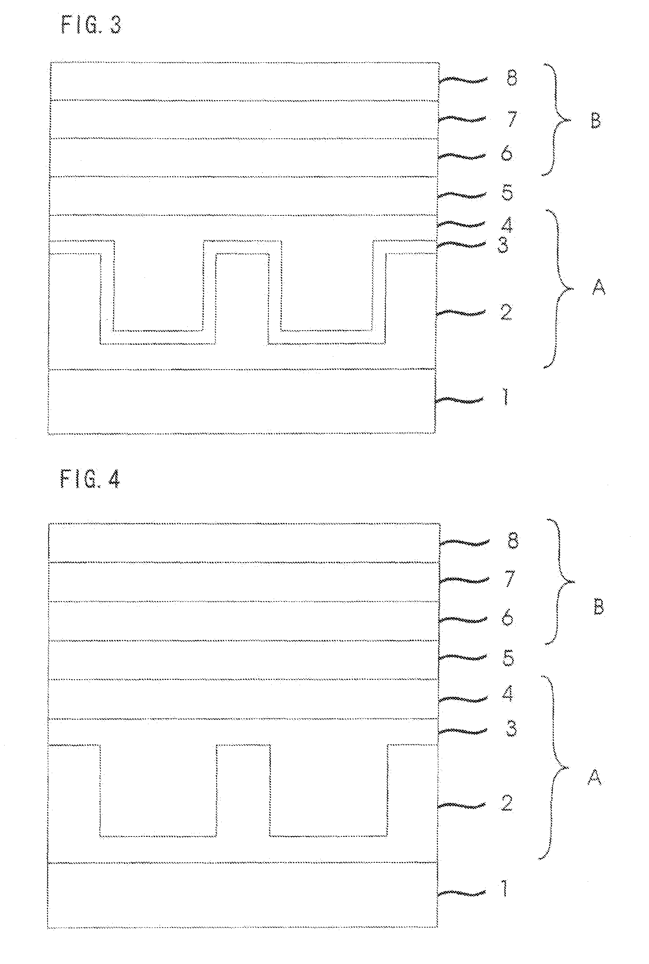

For example, Figure 2 shows that a first layer 2, which is doped n-type, may be formed on a planar substrate 1. The first layer 2 may consist of elongated structures. These elongated structures may be formed directly on the substrate 1 using a mask, self-organization, a seeded substrate, or any other suitable method. Alternatively, a planar layer may be deposited and the elongated structures formed by any suitable etching technique to form the first layer 2. These elongated structures may or may not be connected to each other by a layer of the same material at the interface to the substrate. As shown in Figure 2 a p-type layer 4 may be deposited on the elongated structures such that the surface of the p-type layer 4 is planar. Alternatively, an intrinsic layer may be deposited between the n-type layer 2 and the p-type layer 4. For example, an intrinsic layer 3 may be deposited conformally on the n-type layer 2 as shown in Figure 3. Alternatively the intrinsic layer 3 may be deposited such that the surface is planar as shown in Figure 4. Alternatively, the intrinsic layer 3 may be omitted. Layers 2, 3 (if present), and 4 together form a first subcell A of the photovoltaic device. A tunnel junction layer 5 may be deposited on the uppermost layer 4 of the first subcell A. A planar n-type layer 6 may be deposited on the tunnel junction layer 5. A planar intrinsic layer 7 may be deposited on the n-type layer 6. Alternatively the intrinsic layer 7 may be omitted. A planar p-type layer 8 may be deposited on the n-type layer 6 or the intrinsic layer 7 if present. Layers 6, 7 (if present), and 8 form a second subcell B of the photovoltaic device. Further subcells consisting of p-n or p-i-n junctions containing either elongated structures or planar layers may be deposited on top of the second subcell B. Further subcells consisting of p-n or p-i-n junctions may be deposited on the substrate prior to the deposition of layer 2. In this case layer 2 will be deposited on the uppermost layer of a subcell instead of the substrate. The substrate may also have been treated to form a further subcell in the photovoltaic structure. Each subcell will be separated by an appropriate tunnel junction.

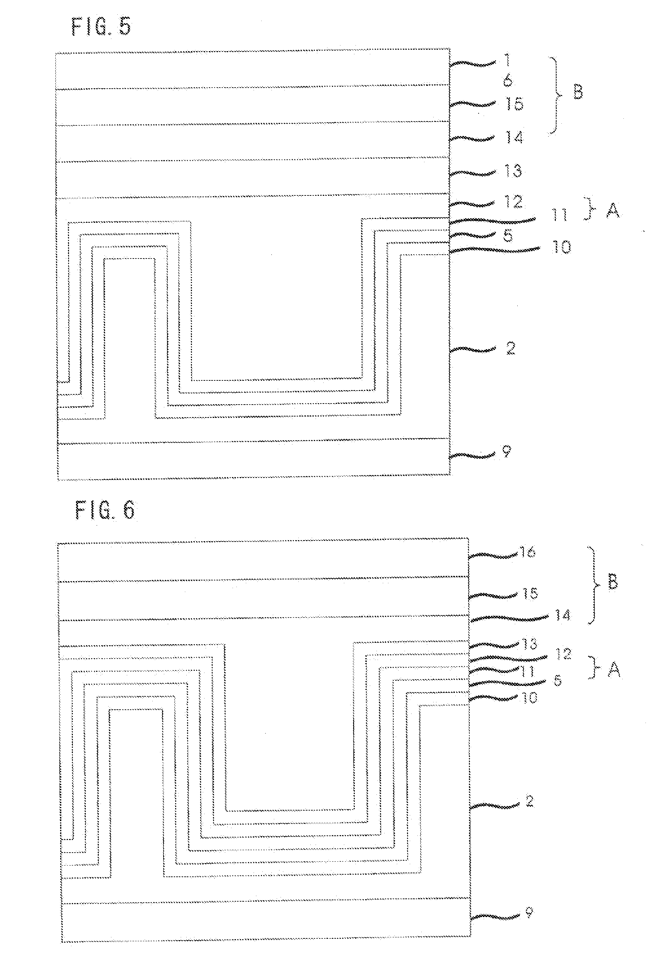

Alternatively, as shown in Figure 5, the substrate surface of a photovoltaic device may consist of a first layer 2 having the elongated structures. These elongated structures 2 may be formed directly on a substrate using a mask, self-organization, a seeded substrate, or any other suitable method. Alternatively, the elongated structures may be formed by any suitable etching technique. If the first layer 2 serving as the substrate has been formed to act as an additional subcell then the elongated structures will form part of the p-type uppermost layer of the first layer 2, with an n-type region 9 below as shown in Figure 5. A buffer layer 10 may be deposited conformally on the surface of the substrate. Alternatively the buffer layer 10 may be omitted. A tunnel junction layer 5 may be deposited conformally on the buffer layer 10 (if present) or the substrate layer 2. A first n-type layer 11 of a subcell A may be deposited conformally on the tunnel junction layer 5. A second p-type layer 12 of a subcell A may be deposited on the n-type layer 11 such that the surface of the p-type layer 12 is planar. Alternatively, as shown in Figure 6, the p-type layer 12 may be deposited conformally on the n-type layer 11. A tunnel junction layer 13 may be deposited conformally on the p-type layer 12, and a first n-type layer 14 of a subcell B may be deposited on the tunnel junction layer 13 such that the surface of the n-type layer 14 is planar as shown in Figure 6. Alternatively, in the embodiment of Figure 5 a planar tunnel junction layer 13 and first n-type layer 14 may be formed on the planar surface of the p-type layer 12. In either embodiment, an intrinsic layer 15 may be deposited on the n-type layer 14 or may be omitted. A planar p-type layer 16 of the subcell B may be deposited on the n-type layer 14 or the intrinsic layer 15 (if present). Further p-n or p-i-n junctions may be deposited conformally between the last layer of subcell A and the first layer of subcell B to form a plurality of p-n junctions with an elongated structure. Further subcells consisting of p-n or p-i-n junctions may be deposited on the subcell B, these additional subcells may be planar, or may contain elongated structures.

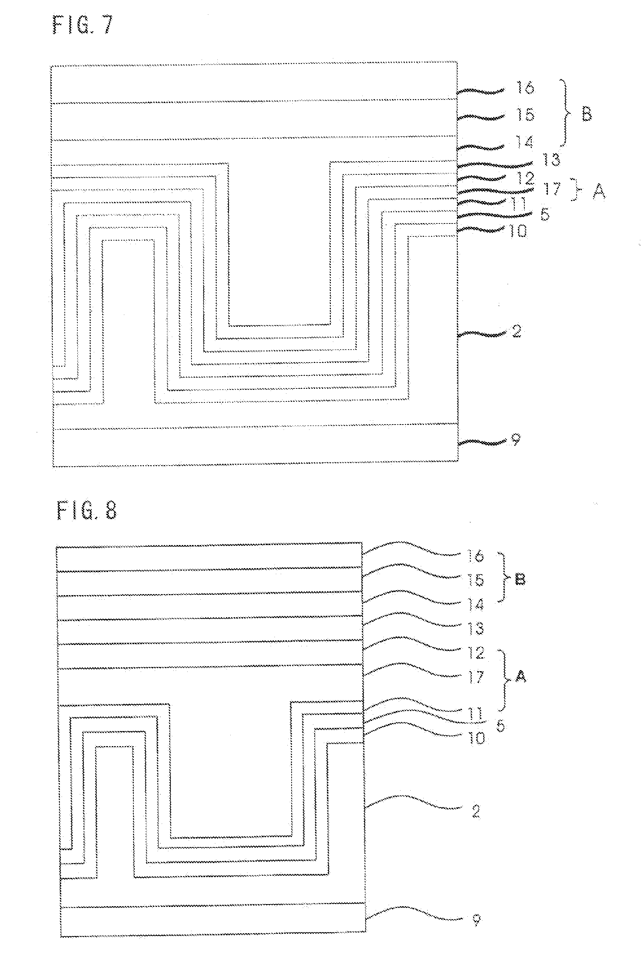

Alternatively, the structure may contain an intrinsic layer 17 between the n-type layer 11 and the p-type layer 12. As shown in Figure 7, the intrinsic layer 17 may be deposited conformally, in which case the p-type layer 12 may be deposited conformally or such that the surface is planar. As shown in Figure 8, the intrinsic layer 17 may be deposited such that the surface is planar, and the p-type layer 12 and subcell B will then be deposited as planar layers.

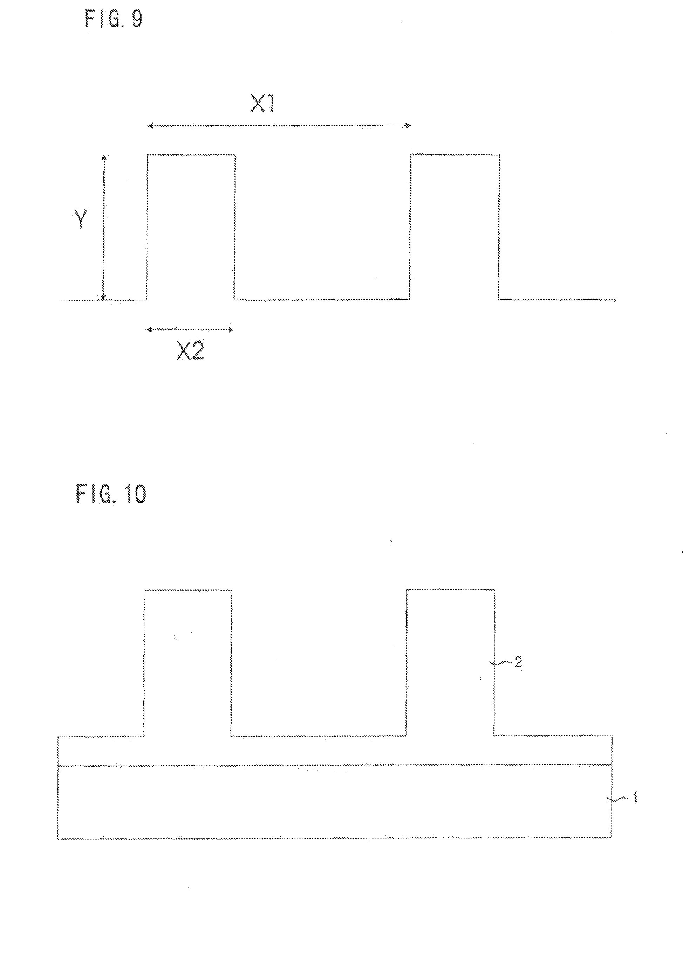

As shown in Figure 9, the preferred pitch X1 of the elongated structures in layer 2 or the other layers as describe herein is between 10nm and 10mm depending on the carrier diffusion length in the material being used and the thicknesses of the layers that are deposited conformally on the elongated structures. The preferred width X2 of the elongated structures is between 10nm and 10mm depending on the carrier diffusion length of the material being used. The preferred height Y of the elongated structures is between 10nm and 10mm depending on the absorption coefficient of the material being used, where Y>X2 to satisfy the condition that the structure is an elongated structure, and X1>X2 to avoid merging of neighbouring elongated structures.

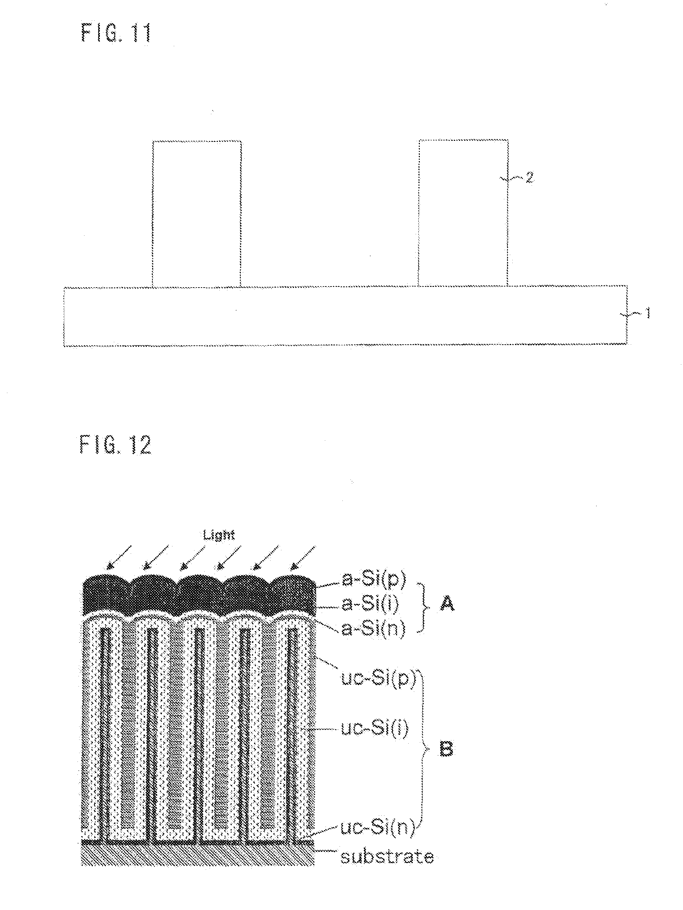

In all of the following embodiments the elongated structures of the first layer 2 may be connected to each other by a planar layer of the same material as the elongated structures, such that the planar layer is in contact with the layer below 1, as shown in Figure 10. Alternatively, the elongated structures of the first layer 2 may not be connected to each other by a layer of the same material, as shown in Figure 11.

In a first particular embodiment of the invention, the photovoltaic device structure consists of an elongated structured subcell with one or more additional planar subcells, where the structured subcell is the one closest to the substrate, and at least one planar subcell is on top of the structured one. The structured subcell contains a set of elongated structures such as fins or a set of pillars, and such a set of fins or pillars has substantially uniform pitch and height. The fins or pillars are made of a conductor, or a semiconductor, or an insulator. Each individual subcell including the structured one contains a p-n/p-i-n junction, which consists of a p-doped semiconductor, an optional non-doped semiconductor and an n-doped semiconductor.

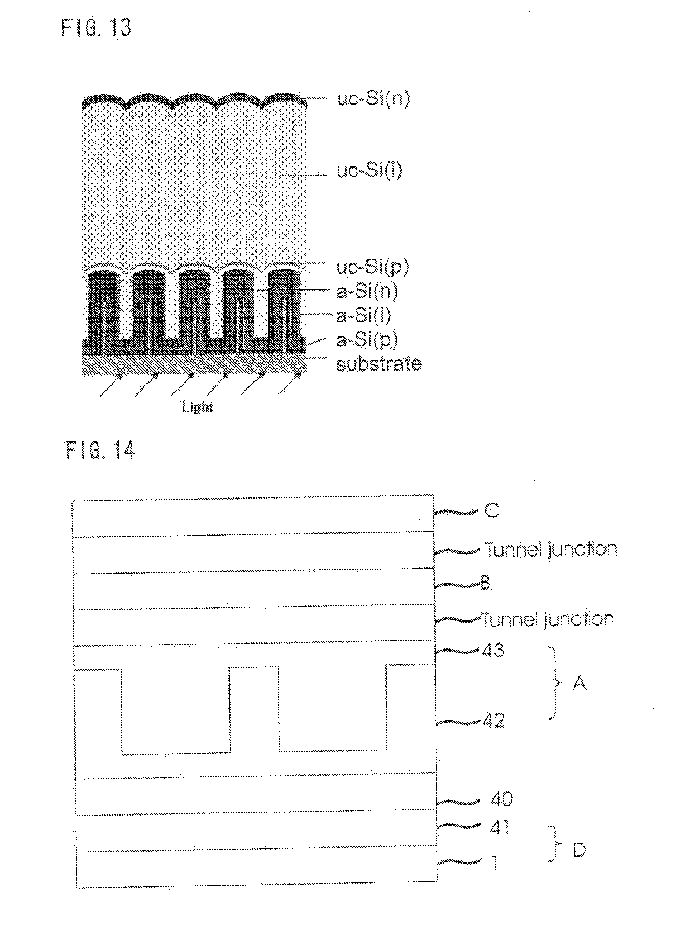

One particular application is an amorphous silicon/microcrystalline silicon (hereafter referred to as a-Si/µc-Si) tandem cell, but the design is not limited to this material combination. In this type of photovoltaic device, the preferred pitch X1 of the fins or pillars is within the range of 500nm to 5µm, while the preferred height Y of the fins or pillars is in the range of 1µm to 10µm. There are two possible configurations. Configuration 1, as shown in Figure 12, has a 3D structured µc-Si subcell and a planar a-Si subcell. The µc-Si structured sub-cell is directly formed on the substrate and an additional a-Si sub-cell is created on top of the µc-Si. Incident light enters the structure on the side furthest from the substrate. Configuration 2, as shown in Figure 13, has a 3D structured a-Si subcell and a planar µc-Si subcell. In Configuration 2, the a-Si sub-cell is 3D structured and is the sub-cell closest to the substrate. A µc-Si subcell is created on top of the a-Si subcell. Incident light enters the structure from the substrate side. Such application of present invention will potentially improve the conventional a-Si/uc-Si thin film technology. One problem, which has been mentioned before, is that the µc-Si cells require much thicker i-layers to absorb the sunlight due to its lower absorption coefficients. However, one cannot just simply increase the thickness of the cell to improve the absorption; this is because as one increases the thickness of the cell, the carrier extraction coefficient is going down due to limited carrier diffusion length. The key idea of present invention is to decouple the carrier diffusion path to the light absorption depth; hence a thicker µc-Si cell can be used without affecting the carrier extraction coefficient.

Another problem when fabricating a a-Si/µc-Si tandem cell is the variation of film thickness across a large substrate during the CVD deposition process. The thickness of each subcell affects the amount of the light it absorbs and hence the photo-generated current. Therefore, the thickness variation in a film is a disadvantage for achieving good current matching between adjacent subcells for the entire device, as the excess current generated in the thicker subcells cannot be extracted and is lost as heat. This reduces the overall efficiency of a photovoltaic device. When using a structured subcell, the thickness of the structured subcell is mainly controlled by the height of the initial vertical structures rather than the thickness of the film deposited around these vertical structures. Therefore, the film uniformity will be improved provided the height of the vertical structures is larger than the thickness of the film and the vertical structures have a substantially uniform height.

A a-Si/µc-Si tandem cell is usually fabricated via chemical vapour deposition (CVD) technology, therefore by providing a substrate which has a set of substantially vertical structures, such a structured a-Si/µc-Si tandem cell can be obtained through subsequent substantially conformal CVD deposition. In both configurations, the set of fins or pillars are part of the substrate, and the subsequent doped Si/non-doped Si/doped Si layers coated around these fins or pillars form a three-dimensional junction.

In any tandem/multi-junction photovoltaic devices, current matching between adjacent subcells is important. The performance of each subcell will set an upper-limit for the maximum possible current that can be extracted from other subcells, and hence can limit the output current of whole photovoltaic devices. A major advantage of having such a structured subcell is that the performance of a potentially poorer subcell can be enhanced due to these three-dimensional junctions, which decouples the light absorption depth and carrier extraction length. Longer light absorption depth can now be achieved while keeping the carrier extraction length short, therefore improving the overall current generation of a photovoltaic device. Adjacent subcells may have different band gap energies and the elongated structures improve current matching between the first subcell and the second subcell.

The vertical or elongated structures on the substrate can be formed by either additive or subtractive method, where the additive and subtractive methods may be defined as following.

Additive (e.g. deposition, transfer):
Deposition methods include but are not restricted to direct or indirect thermal evaporation, sputter deposition, chemical vapour deposition, spin coating, and ink-jet printing.

Transfer methods include dry transfer methods such as stamp-based transfers, and device bonding as well as wet transfer methods where the transfer of the desired structures occurs out of solution.

Subtractive (e.g. etching, sputtering, and dissolving):
Etching includes wet-chemical etching and dry etching (e.g. reactive ion etching). Dry etching techniques may be combined with sputtering techniques.

Sputtering includes ion milling.

The vertical or elongated structures on the substrate will have the same material composition as the substrate if they are formed via subtractive method, or they can be made of insulator (glass, polymers), conductor (conducting metal oxides, metals) or semiconductor (doped or non-doped Si) if they are formed via additive method.

In Configuration 2 (Figure 13), the pitch of the elongated structures is preferred to be within the range of 100nm to 1µm. The height of the elongated structures may be less than 5µm, and is preferred to be less than 2µm. In Configuration 1 (Figure 12), the pitch of the elongated structures may be less than 10µm, and is preferred to be less than 5µm. The height of the elongated structures may be less than 20µm, and is preferred to be less than 10µm. In any of the two configurations, the vertical or elongated structures can be a set of 1D pillars or 2D ribs and their smallest dimension is preferred to be less than 100nm. Before depositing any semiconductor films around these vertical structures to form p-n/p-i-n junctions, a conducting layer (metal or conducting metal oxides) may be applied to the surface of this structured substrate.

The sequential plurality of films coated around these elongated structures can be deposited via methods such as chemical vapour deposition (CVD), molecular beam epitaxy (MBE), Vapour Phase Epitaxy (VPE), Atomic Layer Deposition (ALD), sputtering, electro-deposition, thermal evaporation etc. The overall thickness of these films which forms the first sub-cell is required to completely fill the gaps between neighbouring vertical structures. The second sub-cell which is a planar one is then formed on top of the first structured sub-cell by further depositing a plurality of films that give the p-n/p-i-n junctions.

In another aspect of the present invention the potential improvement to III-V multijunction solar technology is considered. As shown in Figure 14, a photovoltaic cell consisting of subcells of 0.7eV Ge (D), 1eV GaInNAs (A), 1.4eV InGaAs (B) and 1.9eV GaInP (C), contains elongated structures in the GaInNAs subcell (A) as described in the present invention. A planar buffer layer 40 may be deposited on the uppermost layer 41 of the Ge subcell D. A planar tunnel junction layer (not shown) may be deposited on the buffer layer. A layer 42 of elongated structures of n-type GaInNAs may be formed on the tunnel junction layer. The elongated structures may be formed directly on the substrate 1 using a mask, self-organization, a seeded substrate, or any other suitable method as described above. Alternatively, a planar layer may be deposited and the elongated structures formed by any suitable etching technique as described above. Preferably the elongated structures are formed by etching. The elongated structures may be annealed under an arsenic overpressure to improve the material quality. A layer of p-type GaInNAs 43 may be deposited on the elongated structures of layer 42 such that the surface of the layer is substantially planar. The remaining planar subcells (B and C) and appropriate tunnel junctions may be deposited on the GaInNAs subcell A.

The elongated structures have substantially uniform pitch, height and width. Due to low mobility of the carriers and short carrier lifetimes, the carrier diffusion length in GaInNAs is too short, resulting in the GaInNAs subcell A not providing sufficient current to match the current produced in the other subcells (D, B and C) and therefore limiting the efficiency of the photovoltaic device. In the present invention the absorption depth of a subcell is controlled by the height of the elongated structures (Y). Increasing Y increases the current produced in the GaInNAs subcell A. The low carrier diffusion length in GaInNAs only restricts the appropriate values of the width X2 and the pitch X1 of the elongated structures and these can be optimized separately from the height y. This allows the use of a 1eV subcell A in the multijunction structure without it limiting the current from the other subcells (D, B and C) and therefore an overall improvement in device efficiency is predicted. The height of the elongated structures is preferably in the range 0.5mm to 5mm, the width of the elongated structures is preferably in the range 50nm to 500nm and the pitch of the elongated structures is preferably in the range 500nm to 5mm.

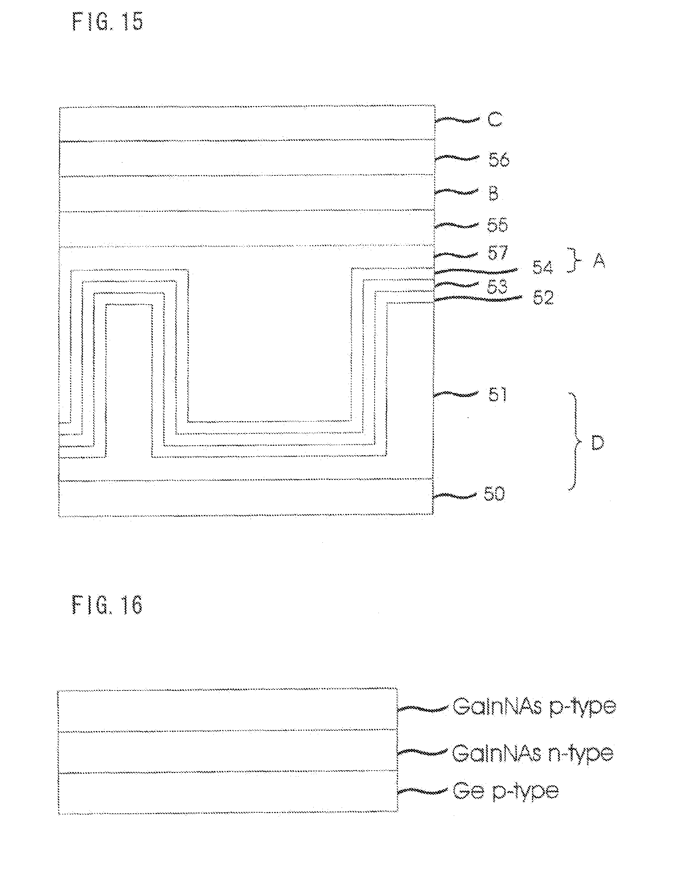

As shown in Figure 15, in a fourth embodiment of the present invention a photovoltaic cell consists of subcells of 0.7eV Ge (D), 1eV GaInNAs (A), 1.4eV InGaAs (B) and 1.9eV GaInP (C). The n-type layer 50 of the Ge subcell D is planar, and the p-type layer 51 of the Ge subcell contains elongated structures. The elongated structures have substantially uniform pitch, height and width. The height Y of the elongated structures is preferably in the range 0.5mm to 5mm, the width X2 of the elongated structures is preferably in the range 50nm to 500nm and the pitch X1 of the elongated structures is preferably in the range 500nm to 5mm. A buffer layer 52 may be deposited conformally on the Ge subcell p-type layer 51, or the buffer layer may be omitted. A tunnel junction layer 53 may be deposited conformally on the buffer layer 52 or the p-type Ge layer 51. A GaInNAs n-type layer 54 may be deposited conformally on the tunnel junction layer 53. A GaInNAs p-type layer 57 may be deposited on the GaInNAs n-type layer 54, and p-type layer 57 may be planarized such that the surface of the layer 57 is substantially planar. The remaining planar subcells (B and C) and appropriate tunnel junctions (e.g., 55 and 56 may be deposited on the GaInNAs subcell (2). Similarly to that described in the third embodiment this structure allows the height Y of the elongated structures to be optimized for the absorption depth independently from the parameters (the pitch X1 and the width X2) that depend of the carrier diffusion length in the material. This structure has the additional advantages of forming the elongated structures in the Ge substrate rather than the more difficult GaInNAs material and also benefits from improved carrier extraction due to the carriers travelling more of the distance in the high quality p-type Ge layer 51 rather than the lower quality n-type GaInNAs layer 54.

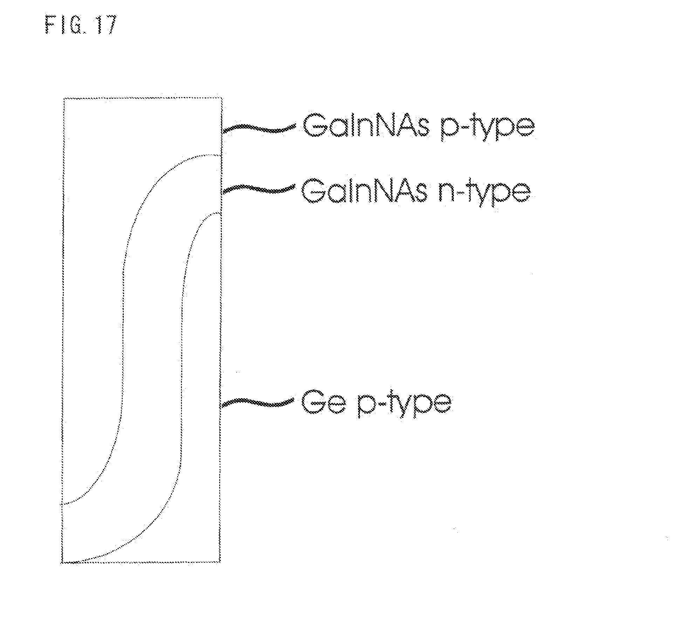

To illustrate the concept of the present invention a simplified structure of the GaInNAs subcell A as described in this fourth embodiment (Figure 15) was simulated and compared with a planar GaInNAs subcell. The unit cell used for the planar cell is shown in Figure 16; the unit cell used for the subcell A containing elongated structures is shown in Figure 17. The software used was sentaurus TCAD v 2008.09. The cell was modeled as a 2D structure and was illuminated with an AM1.5G spectrum between 750-1300nm (to simulate the light that would pass through the higher bandgap 1.4eV InGaAs (B) and 1.9eV GaInP (C) subcells), the light was propagated through the cell using ray-tracing. An optical generation profile was created from this ray-trace, for which an I-V simulation was carried out by biasing contacts at the top and bottom of the cell from V=0 until V=Voc. From the resulting I-V curve the maximum power, and hence % efficiency, was extracted. The electron mobility used was 300cm2/Vs; the hole mobility used was 30cm2/Vs. Details of the absorption spectrum used can be found in G. Leibiger et al, J. Appl. Phys. 90 (12) 5951 (2001).The planar cell (Figure 16) had a 0.9mm planar layer of n-type GaInNAs deposited on planar p-type germanium Ge, and a 0.9mm planar layer of p-type GaInNAs deposited on the n-type GaInNAs. The 3D structured cell (Figure 17) had a p-type germanium Ge layer with elongated structures of height (Y) 3mm, pitch (X1) 1.8mm and width (X2) 0.1mm, a 0.4mm layer of n-type GaInNAs deposited conformally on the elongated germanium structures and a 0.4mm layer of p-type GaInNAs deposited conformally on the n-type GaInNAs such that the surface of the p-type GaInNAs layer is substantially planar. The efficiency of the planar GaInNAs cell (Figure 16) was 2.16%; the efficiency of the 3D structured cell (Figure 17) was 3.12%. The overall increase in efficiency, in 2D simulations, between the planar cell (Figure 16) and the 3D structured cell (Figure 17) was 44%.

In the third and fourth embodiments the photovoltaic devices are preferably grown by molecular beam epitaxy using silicon as the n-type dopant and beryllium as the p-type dopant. Solid sources are preferably used for the gallium, indium, silicon and beryllium, cracker cells for the arsenic and phosphorous, and an RF plasma source for the nitrogen. The GaInNAs layers are preferably grown in the temperature range 400-550°C, the InGaAs layers are preferably grown in the temperature range 600-750°C and the GaInP layers are preferably grown in the range 500-600°C. However other material sources and growth conditions may be used. Other growth methods may also be used; this includes but is not limited to, chemical vapour deposition, vapour phase epitaxy and chemical beam epitaxy.

The method can also include at least one additional subcell (second subcell) in tandem with the first subcell having either a p-n or p-i-n junction with elongated structures, or a planar p-n or p-I-n junction. The first subcell can be one of a µ c-Si subcell and an a-Si subcell, and the second subcell can be the other of a µ c-Si subcell and an a-Si subcell. The first subcell can also be a GaInNAs subcell and the elongated structures can comprise of at least one of ribs or pillars.

This invention has been described with reference to embodiments of photovoltaic devices with the three-dimensional subcell consisting of GaInNAs, a-Si or mc-Si. However the present invention is not limited to these materials, and may be applied by one skilled in the art to any material(s) where a benefit would be gained by the use of the present invention.

### INDUSTRIAL APPLICABILITY

The present invention enables a gain in the efficiency of multijunction photovoltaic devices by decoupling the requirements based on the necessary absorption depth and the possible minority carrier diffusion length in the material of a subcell; and/or to provide a structure that is quicker and easier to fabricate compared with present technology.

## Claims

1. A multijunction photovoltaic structure, comprising:
a first subcell including a p-n or p-i-n junction with elongated structures; wherein the elongated structure is a structure that has a height larger than at least one of a length and a width, and
a second subcell, arranged in tandem with the first subcell, and including a planar p-n or p-i-n junction.

2. The multijunction photovoltaic structure according to claim 1, wherein a pitch of the elongated structures of the first subcell is between 10nm and 10 µ m;
and/or wherein a width of the elongated structures of the first subcell is between 10nm and 10 µ m;
and/or wherein a height of the elongated structures of the first subcell is between 10nm and 10 µ m.

3. The multijunction photovoltaic structure according to any one of claims 1-2, wherein the p-n junction with elongated structures of the first subcell comprise a p-type or n-type layer with three-dimensional structures formed therein, and the other of the p-type or n-type layer deposited on top thereof; and optionally wherein the other of the p-type or n-type layer is planarized.

4. The multijunction photovoltaic structure according to any one of claims 1-2, wherein the p-i-n junction with elongated structures of the first subcell comprise a p-type or n-type layer with three-dimensional structures formed therein, an intrinsic layer deposited on top thereof, and the other of the p-type or n-type layer formed on top of the intrinsic layer; and optionally wherein the intrinsic layer is planarized.

5. The multijunction photovoltaic structure according to any one of claims 1-2, wherein the elongated structures of the first subcell comprise respective layers of the p-n or p-i-n junction deposited conformally on top of a substrate or underlying layer having three-dimensional structures corresponding to the elongated structures.

6. The multijunction photovoltaic structure according to any one of claims 1-5, wherein the first subcell and the second subcell have different band gap energies and the elongated structures improve current matching between the first subcell and the second subcell.

7. The multijunction photovoltaic structure according to any one of claims 1-6, wherein the first subcell is one of a µ c-Si subcell and an a-Si subcell, and the second subcell is the other of a µ c-Si subcell and an a-Si subcell.

8. The multijunction photovoltaic structure according to any one of claims 1-6, wherein the first subcell is an GaInNAs subcell.

9. The multijunction photovoltaic structure according to any one of claims 1-8, further comprising a tunnel junction separating the first subcell and the second subcell.

10. The multijunction photovoltaic structure according to any one of claims 1-9, further comprising at least one additional subcell in tandem with the first subcell, said additional subcell having either a p-n or p-i-n junction with elongated structures, or a planar p-n or p-i-n junction.

11. The multijunction photovoltaic structure according to any one of claims 1-10, wherein the elongated structures comprise at least one of ribs or pillars.

12. A method for forming a multijunction photovoltaic structure, comprising:
forming a first subcell including a p-n or p-i-n junction with elongated structures; wherein the elongated structure is a structure that has a height larger than at least one of a length and a width, and
forming a second subcell, arranged in tandem with the first subcell, and including a planar p-n or p-i-n junction.

13. The method of claim 12, comprising forming a p-type or n-type layer of the first subcell including the p-n junction with three-dimensional structures therein, depositing the other of the p-type or n-type layer thereon.

14. The method of claim 12, comprising forming a p-type or n-type layer of the first subcell including the p-i-n junction with three-dimensional structures therein, depositing an intrinsic layer thereon, and forming the other of the p-type or n-type layer on top of the intrinsic layer.

15. The method of claim 12, comprising forming the elongated structures of the first subcell by depositing the respective layers of the p-n or p-i-n junction conformally on top of a substrate or underlying layer having three-dimensional structures corresponding to the elongated structures.
